# DEMANDE DE BREVET EUROPEEN

(11) **EP 2 386 986 A1**
(43) Date de publication de la demande: **16.11.2011**
(21) Numéro de dépôt: 10305457.3
(22) Date de dépôt: 29.04.2010
(51) Int. Cl.: G06K 19/077

(54) **Procédé de connexion d'un composant électronique par boucle en fil soudé et dispositif obtenu**

(71) Demandeur: Gemalto SA, 92190 Meudon (FR)
(72) Inventeur: Seban, Frédérick, 13260 Cassis (FR); Audouard, Laurent, 13400 Aubagne (FR); Bajolle, Antoine, 13390 Auriol (FR)

(57) **Abrégé**

L'invention concerne un procédé de connexion d'un composant électronique comportant au moins une plage de contact électrique (1, 1A, 21, 22), à au moins un contact électrique externe (2, 32), ledit procédé comprenant l'étape de formation d'au moins un élément de connexion (4, 14) sur chaque plage de contact du composant, par soudure d'une première extrémité (3, 13) d'une portion de fil électrique à ladite plage de contact électrique et de fixation d'une seconde extrémité (5, 15) du fil opposée à la première extrémité, sur une surface externe du composant de manière à offrir une boucle conductrice (4, 14) entre les deux extrémités de fil;

Le procédé se distingue en ce que pour la connexion, une zone de contact (6) disposée sur une périphérie externe de la boucle est utilisée pour connecter ledit contact externe (2, 32) par simple pression de contact.

L'invention concerne également le dispositif obtenu.

## Description

L'invention concerne un procédé de connexion d'un composant électronique comportant au moins une plage de contact électrique à au moins un contact électrique externe.

L'invention concerne plus particulièrement le domaine de la fabrication des cartes à puces et plus particulièrement la connexion de modules électroniques pour cartes à puce capables de fonctionner sans contact à l'aide d'une antenne intégrée dans la carte.

De telles cartes sont destinées à réaliser diverses opérations, telles que, par exemple, des opérations bancaires, des communications téléphoniques, des opérations d'identification, des opérations de débit ou de rechargement d'unités de compte, et toutes sortes d'opérations qui peuvent s'effectuer à distance par couplage électromagnétique à haute fréquence entre une borne d'émission-réception et une carte placée dans la zone d'action de cette borne.

Un des problèmes techniques principaux qu'il faut résoudre dans la fabrication de telles cartes est la connexion de l'antenne à la puce de circuit intégré qui assure le fonctionnement électronique de la carte. Les contraintes classiques de tenue mécanique, de fiabilité, et de coût de fabrication doivent être prises en compte dans cette fabrication.

L'invention a pour objet de proposer un procédé de fabrication qui permet de résoudre au mieux le problème de la connexion électrique entre la puce ou module le comportant et l'antenne.

On connait le brevet FR 2761527 décrivant la réalisation de pattes de connexion filaires par portion de fil soudé directement sur les plots électriques de puces de circuits intégrés. Ce document décrit de connecter avec le même fil, deux plots distincts d'une même puce ou de puces différentes adjacentes sur une galette de semi-conducteur puis de scier les fils en leur milieu au cours notamment de la séparation des puces entre-elles. La connexion des puces à une antenne s'effectue ensuite par tout moyen de connexion par soudure à chaud ou à froid des portions résiduelles de fils à des portions terminales d'une antenne.

En d'autres mots, ce brevet utilise la technique très classique de "wire-bonding", « ball-bonding », ou soudage de fil par thermo-compression, c'est-à-dire de soudage de fil (en général d'or ou d'aluminium) sur une puce, mais au lieu d'utiliser cette technique de la manière habituelle, c'est-à-dire en faisant partir un fil depuis un plot de contact de la puce pour l'amener jusqu'à un plot de contact d'un élément de support de puce (habituellement une grille de connexion ou un module de circuit imprimé), il est prévu de souder une extrémité du fil sur un plot de contact de la puce mais sans souder l'autre extrémité sur un élément extérieur sur lequel la puce serait reportée. Le fil reste libre pour servir d'élément de contact en saillie au-dessus de la puce.

Les procédés de l'art antérieur pour le domaine de la carte à puce requièrent des opérations additionnelles et des machines spécifiques notamment des équipements de dispense colle ou de formation de bossages qui viennent s'ajouter à des équipements normaux de connexion de la puce et de report de module.

L'invention vise à résoudre les inconvénients précités. Elle vise à faciliter encore plus la connexion du composant à l'antenne et à être encore plus économique par une simplification des opérations. Elle vise aussi à augmenter la fiabilité des connexions électriques.

Le principe de l'invention consiste à réaliser sur chaque contact des bossages élastiques conducteurs (bumps) en forme de boucle par technique de fil conducteur soudé; La connexion s'établit ensuite de préférence par simple pression de contact entre la boucle et une surface conductrice à connecter.

A cet effet, l'invention a pour objet un procédé de connexion d'un composant électronique comportant au moins une plage de contact électrique, à au moins un contact électrique externe, ledit procédé comprenant l'étape de formation d'au moins un élément de connexion souple sur chaque plage de contact du composant, par soudure d'une première extrémité d'une portion de fil électrique à ladite plage de contact électrique et de fixation d'une seconde extrémité du fil opposée à la première extrémité, sur une surface externe du composant de manière à offrir une boucle conductrice entre les deux extrémités de fil;

Le procédé se distingue en ce qu'il utilise une zone de contact sur une périphérie externe de la boucle pour connecter ledit contact externe par simple pression de contact.

Selon d'autres caractéristiques de l'invention,
- la seconde extrémité de la portion est soudée sur la même plage de contact;
- le composant est un module sans-contact (et/ou à contacts) comportant deux plages de contact électrique destinés à connecter une antenne;
- chaque élément de connexion est formé au cours d'une étape de raccordement d'une puce de circuit intégré aux plages de contact du module électronique;
- Pour la connexion aux contacts électriques externes, on reporte et fixe le module dans une cavité de corps de carte, les éléments de connexion venant se déformer élastiquement contre les plages de contact externes et connecter par simple pression de contact lesdites plages électriques externes.

L'invention a également pour objet un dispositif correspondant obtenu par le procédé et un produit électronique de communication radiofréquence, tel une carte à puce sans-contact, comprenant ou formant le dispositif.

D'autres particularités et avantages de l'invention apparaîtront à la lecture de la description, qui suit, donnée à titre d'exemple illustratif et non limitatif, et faite en référence aux figures annexées pour lesquelles :
- la figure 1 illustre une vue schématique partielle d'un dispositif de l'invention en cours d'assemblage et pouvant être obtenu selon un premier mode de mise en oeuvre du procédé de l'invention;
- la figure 2 illustre une vue schématique partielle d'un dispositif de l'invention en cours d'assemblage et pouvant être obtenu selon un second mode de mise en oeuvre du procédé de l'invention;
- la figure 3 illustre une vue d'un module électronique de type carte à puce en vue de dessous, ledit module comportant les deux types d'élément de connexion en étant agencés croisés ou non;
- la figure 4 illustre une vue en coupe d'un module conforme à la figure 3 mais avec une seule boucle par plage de contact;
- La figure 5 illustre une vue en coupe d'une carte à puce comportant le module de la figure 4 connectée selon l'invention à une antenne.

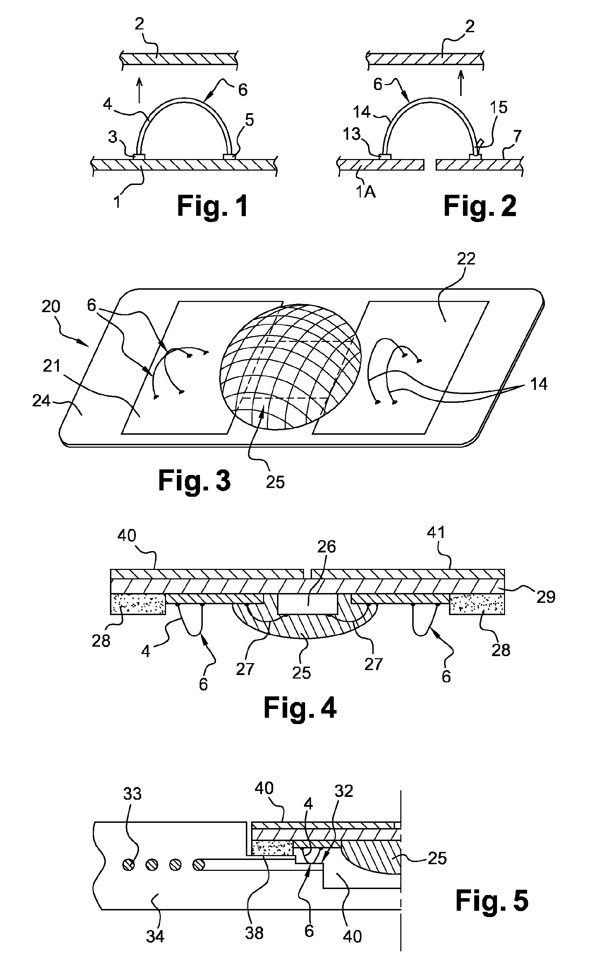

Conformément à un mode de réalisation de l'invention, à la figure 1, au moins une plage de contact électrique 1 d'un composant électronique (non représenté) est destinée à connecter au moins un contact électrique externe 2 d'un dispositif quelconque (non représenté); ce dernier contact 2 peut appartenir à tout dispositif distinct du composant 1. Le procédé comprend un étape de formation d'au moins un élément de connexion souple 4 sur chaque plage de contact 1 du composant par soudure d'une première extrémité 3 d'une portion de fil électrique 4 à la plage de contact électrique du composant 1,

Dans l'exemple on utilise avantageusement la technologie de fil soudé du type "wire, edge ou ball bonding"

D'autres technologies sont utilisables comme la thermo compression ou dépôt de fil non isolé par ultrasons.

Selon une caractéristique de l'invention, le procédé comporte une étape de fixation recourbement d'une seconde extrémité 5 du fil (opposée à la première extrémité 3) sur une surface externe du même composant. Ce recourbement est effectué de manière à offrir une boucle conductrice entre les deux extrémités de fil et une zone de contact 6 sur une périphérie externe de la boucle;

Selon un premier mode de mise en oeuvre, la fixation de la seconde extrémité 5 de la portion de fil est effectuée par soudure du fil à la même plage de contact 1. La zone de contact 6 du fil (portion bombée externe de la boucle ou rayon de courbure externe) est destinée à connecter le contact électrique externe 2 par simple pression de contact au cours d'un simple rapprochement entre eux (symbolisé par la flèche). L'élément de connexion 4 viendra ensuite se déformer élastiquement contre la plage de contact 2 au cours de ce rapprochement.

A la figure 2, les éléments portant les mêmes numéros qu'à la figure 1 sont identiques; on fixe un fil conducteur 14 par une extrémité 13 sur une plage de contact 1A d'un composant et on procède de la même manière que précédemment sauf pour la seconde extrémité qui est fixée à une surface distincte de la plage de contact 1A. Ici cette surface 7 est un isolant électrique. La fixation peut être réalisée par tout moyen (mécanique, adhésif, soudure à chaud ou froid dans le cas où la surface est conductrice comme à la figure précédente)

Aux figures 3 et 4, le composant est un module sans-contact 20 pour carte à puce de type "combi" à interface duale (à contacts et sans-contact). Il comporte deux plages de contact électrique 21, 22 sur un substrat diélectrique 24 et un enrobage 25 d'un microcircuit électronique 26 relié aux plages de contact par des connexions 27 de type fil soudé. Il comprend également un ensemble de plages de contact électrique externes 40, 41 selon la norme ISO 7816 pour communiquer avec un terminal de type à contacts électriques.

Le module de la figure 3 comprend plusieurs éléments ou zone de connexion 6 sur chaque plage de contact 21, 22 formés respectivement comme sur les figures 1 et 2. Sur la plage 21, les fils sont croisés au sommet tandis que pour la plage 22, les fils ne se croisent pas. Contrairement à la figure 2, l'extrémité 15 est fixée sur la même plage de contact 22. Cette extrémité est une simple soudure contrairement à la fixation des extrémités 13, 3 et 4 qui comprennent un point de soudure plus étendu (type « ball bonding »).

De manière avantageuse, chaque élément de connexion 4, 14 (ou boucle) est formé au cours d'une étape de raccordement des plots du microcircuit électronique 26 (comprenant ici une puce de circuit intégré) aux deux plages de contact 21, 22 du module électronique 20. Cela signifie que l'on peut effectuer ces éléments de connexion 4, 14 avec un équipement existant, au même poste de travail et/ou avec la même tête de soudure que celui et/ou celle utilisé(s) pour connecter la puce de circuit intégré au module.

Grâce à l'invention on évite d'utiliser des équipements supplémentaires. L'équipement de réalisation de fil soudé comporte ne plus du programme destiné à piloter la connexion de la puce au module, un programme destiné à piloter la réalisation des boucles sur les plages de contact interne du module et selon un motif ou modèle déterminé (une boucle, deux, croisés ou non, en forme de dôme...).

A la figure 5, on a représenté un exemple de connexion d'un composant à des contacts électriques d'un dispositif après avoir été préparé conformément à l'invention

Les contacts externes sont ici constitués par des plages de contacts terminales 32 d'une antenne 33 à plusieurs spires noyées dans un corps 34 de carte à puce. Le composant est représenté par le module de la figure 4 qui se trouve sur la figure 5 dans un état de report dans une cavité 40 du corps de carte et de raccordement électrique à l'antenne 33. L'antenne est réalisée en fil incrusté et subit un usinage aux bornes pour être dénudé à l'occasion de la formation des différents plans constituant la cavité

Préalablement à l'encartage du module, ce dernier comporte un film adhésif 28 de type thermo adhésif fixé au moins sur une périphérie du module et dont la surface correspond à une surface de collage équivalente 38 présente dans la cavité.

Le raccordement électrique du module à l'antenne s'effectue comme à la figure 1 en rapprochant les contacts à connecter. Pour cela le module est reporté dans une cavité 40 de corps de carte, les éléments de connexion 6 venant se déformer élastiquement contre les plages de contact 32 de l'antenne et connecter par simple pression de contact lesdites plages électriques externes 32. Le film adhésif 28 est activé préalablement par UV ou infrarouge ou postérieurement au report par transfert thermique et pression.

Grâce à l'invention, il n'est pas nécessaire d'avoir un poste supplémentaire de connexion du module à l'antenne tel qu'un poste de dispense de colle conductrice, de formation d'excroissance spécifique sur les plages de contact 21, 22 ou un poste d'extraction de fils d'antenne hors du corps de carte et de soudure au module avant encartage.

L'avantage de ces connexions élastiques est aussi de garantir un bon contact ohmique en cas de flexion extrêmes de la carte.

En d'autres termes, l'invention permet une application particulièrement avantageuse aux modules pour carte à puce. Un mode de mise en oeuvre de l'invention est de réaliser des "excroissances" sur les plages de contact d'un module de type "combi" avec des éléments de connexion quasi-identiques à ceux utilisés dans les enrobages pour supporter (comme des étais ou piliers) une pastille de protection isolante placée dessus et destinée à aplanir la résine. Le procédé réalise un câblage par fil soudé (du type ball bonding /wedge/ etc..) sur les plages de contact du module en ayant préalablement défini un calage de hauteur de boucle de façon à avoir le sommet 6 de la boucle 4 s'étendant au delà de la plage de contact et de préférence au delà du substrat 29 des plages de contact 21, 22 (verre époxy) voire aussi d'un film adhésif (tesa, scapa) 28.

De part sa souplesse et son élasticité, ce fil d'or ou d'aluminium rentrera en contact avec une plage de contact de l'antenne 32 réalisant ainsi la connexion.

Il est possible de réaliser plusieurs éléments de connexion qui ce croissent ou pas ou sont parallèles. La rigidité de la connexion résulte des éléments de connexion qui en se croisant, par-dessus pour l'un, par-dessous pour l'autre et ainsi de suite en créant une structure de fils enchevêtrés. Le cas échéant, en plaçant plusieurs éléments de connexion, boucles ou arceaux avec leurs extrémités fixées sur une plage de contact autour d'un cercle et se croissant sensiblement en leur milieu au sommet des arceaux, on forme une structure de dôme élastique beaucoup plus raide.

Que les fils soient ou non croisé ou parallèle entre eux, il n'y a pas de limitation du nombre de fils, qui est limité uniquement par la surface utile sur laquelle ils sont fixés. De préférence, la hauteur de boucle, peut être inférieure à la hauteur maximale de la résine d'enrobage de la puce afin d'éviter d'arracher les fils lors de diverses manipulation (extraction, report module) ; on ce sert de la résine comme protection (ou comme intercalaire de protection) notamment lors de rembobinage d'un ruban de module.

## Revendications

1. Procédé de connexion d'un composant électronique comportant au moins une plage de contact électrique (1, 1A, 21, 22), à au moins un contact électrique externe (2, 32), ledit procédé comprenant l'étape de formation d'au moins un élément de connexion (4, 14) sur chaque plage de contact du composant, par soudure d'une première extrémité (3, 13) d'une portion de fil électrique à ladite plage de contact électrique et de fixation d'une seconde extrémité (5, 15) du fil opposée à la première extrémité, sur une surface externe du composant de manière à offrir une boucle conductrice (4, 14) entre les deux extrémités de fil,
**caractérisé en ce que** pour la connexion, une zone de contact (6) disposée sur une périphérie externe de la boucle est utilisée pour connecter ledit contact externe (2, 32) par simple pression de contact.

2. Procédé selon la revendication 1, **caractérisé en ce que** la seconde extrémité (5, 15) de la portion est soudée sur la même plage de contact.

3. Procédé selon la revendication précédente, **caractérisé en ce que** le composant est un module sans contact (20) comportant deux plages de contact électrique (21, 22).

4. Procédé selon la revendication précédente, **caractérisé en ce que** chaque élément de connexion (4) est formé à l'occasion d'une étape de raccordement des plots d'une puce de circuit intégré (26) aux deux plages de contact (21, 22) du module électronique (20).

5. Procédé selon l'une quelconque des revendications 3 ou 4, **caractérisé en ce que** pour la connexion aux contacts électriques externes (2, 32), on reporte et fixe le module (20) dans une cavité de corps de carte, les éléments de connexion (4) venant se déformer élastiquement contre les plages de contact électrique externes (32) et connecter par simple pression de contact lesdites plages de contact électrique externes.

6. Procédé selon l'une quelconque des revendications précédentes, **caractérisé en ce que** chaque plage de contact comporte plusieurs éléments de connexion se croisant ou non.

7. Dispositif comprenant un composant électronique (20) comportant :
- au moins une plage de contact électrique (1, 1A, 21, 22) connectant ou étant destinée à connecter au moins un contact électrique externe (2, 32),
- au moins un élément de connexion (4, 14) formé sur chaque plage de contact du composant par soudure d'une première extrémité (3, 13) d'une portion de fil électrique à ladite plage de contact électrique et de fixation d'une seconde extrémité (5, 15) du fil opposée à la première extrémité, sur une surface externe (7, 2, 32) du composant de manière à offrir une boucle conductrice entre les deux extrémités de fil
**caractérisé en ce qu'**il comprend une zone de contact (6) disposée sur une périphérie externe de la boucle connectant ou destinée à être utilisée pour connecter ledit contact externe (2, 32) par simple pression de contact.

8. Produit électronique de communication radiofréquence, tel une carte à puce sans-contact, un comprenant ou formant le dispositif selon la revendication précédente.
